# EUROPEAN PATENT APPLICATION

(11) **EP 1 139 712 A2**
(43) Date of publication of application: **04.10.2001**
(21) Application number: 01302259.5
(22) Date of filing: 12.03.2001
(51) Int. Cl.: H05K 9/00

(54) **Article comprising surface-mountable, EMI-shielded plastic cover and process for fabricating article**

(30) Priority: 24.03.2000 US 534891
(71) Applicant: LUCENT TECHNOLOGIES INC., Murray Hill, New Jersey 07974-0636 (US)
(72) Inventor: Decker, Robert LeRoy, Parsippany, NJ 07054 (US); Weld, John David, Ledgewood, NJ 07852 (US)
(74) Representative: Buckley, Christopher Simon Thirsk

(57) **Abstract**

A surface mountable cover for providing EMI shielding is formed of a composition of a conductive additive suspended within a thermoplastic polymeric material in an amount sufficient to allow the article to reflect and absorb incident electromagnetic radiation. The cover is formed of a material which is solderable to a substrate, such as a printed wiring board. The thermoplastic material has a melting point of greater than about 230°C to allow the thermoplastic material to be used in surface mount technology (SMT) processing. The article and electronic components or circuits covered by the article are affixed to a printed wiring board with SMT processing.

## Description

### Background of the Invention

### Field of the Invention

The present invention relates generally to shielding of electronic components and more particularly, to surface mountable plastic covers useful for shielding electronic components from electromagnetic interference (EMI).

### Description of the Related Art

Conductive housings are used to provide shielding of a device from electromagnetic radiation. The disruption of an electronic device as a result of electromagnetic radiation is termed electromagnetic interference (EMI). Typically, all electronic equipment, such as central office switches, desktop and lap top computers and cellular and cordless phones, must be shielded from EMI for proper operation. EMI in the context of this disclosure typically includes frequencies within a range of about 50 hertz to about 10 gigahertz. Absorption and reflection energy losses provided by a shield material are proportional to: (1) the thickness of the shield, (2) the magnetic permeability of the shield material, (3) the frequency of the EMI wave, and (4) the surface resistivity of the shield material. While the defining relationships (i.e. frequencies) for reflection and absorption mechanisms are different, EMI shielding effectiveness is enhanced for materials which have a volume resistivity in the range of about 10⁻⁴ to 10 ohm-cm. For the purpose of this discussion, EMI shielding effectiveness will be described in terms of the volume resistivity. It will be appreciated that volume resistivity is independent of surface resistivity (ohm/square) of the shield material. Accordingly, a shield material can have EMI shielding effectiveness due to having appropriate volume resistivity, but have poor surface resistivity.

A conventional method for providing EMI shielding is to house the electronic equipment in an electrically conductive metal cover. For example, central office switches and outside plant telecommunications equipment are typically housed in metal cabinets. Similarly, desktop and lap top computers use metal cabinetry or internal metal shields to provide shielding from EMI. Cellular phones include a metalized layer on the inside of the phone housing and cordless phones use metalized plastic covers which are attached to an internal printed wiring board (PWB).

EMI shielded covers can be attached to PWBs to provide on-board protection of circuits or components of the PWBs. For example, surface mountable metal covers can be positioned and placed onto the PWB using automated surface mount technology (SMT) during the processing of the PWB. The SMT process comprises the steps of applying a solder paste onto surface pads formed on the PWB, placing electronic components into the solder paste, melting the solder paste to affix the electronic component in the solder paste and testing the affixed electronic components. The reflow process to melt the solder is a high temperature process with maximum temperature ranging from 200°C to 235°C and typically at 220°C.

Multiple metal EMI covers have been used to shield large PWB circuits. The metal covers are formed with conventional metal forming processes such as bending and stamping, thereby limiting the number of shapes of covers obtainable. The metal EMI shielded covers are positioned and placed onto the processed PWB using conventional SMT equipment for picking up and placing surface mount electronic components. Accordingly, the component size and component weight limitations of the SMT determine the maximum size of the EMI shielded covers that can be used in the SMT process.

Alternatively, thermoplastic injection molded EMI shielded covers have been used to provide EMI shielding of electronic components. The thermoplastic covers are mechanically attached to the PWB after completion of SMT processes. The thermoplastic covers are transparent to EMI emissions and secondary processing is used to provide electrical conductivity properties. Conventional secondary processes include applying an electrically conductive layer to the surface of the molded cover. The electrically conductive layer can be formed of electrically conductive paints, electroless copper plating or chrome plating. Electrically conductive paints are typically applied by spraying after masking to prevent unwanted over spray. Electroless copper and chrome plating are chemical dipping processes resulting in covers having a metal layer over the entire surface. Because multiple coating steps are often required to deposit a continuous layer having the desired surface resistivity, the processes used for forming the conductive layer on the plastic material are expensive. Conventional thermoplastic covers are formed of thermoplastic resins such as acrylonitrile-butadiene-styrene (ABS) or polycarbonate. These resins have a low melting point or heat deflection temperature which makes them unsuitable for use in SMT processes because the resin will substantially deform or melt at the temperatures used in SMT processing.

It is desirable to provide a surface-mountable EMI shielded cover which can be directly soldered to a PWB during SMT processing.

### Summary of the Invention

The present invention is directed to an article useful for providing shielding from electromagnetic interference (EMI). The article is formed of a composition in which a metal conductive additive is suspended within a thermoplastic polymeric material in an amount sufficient to provide a volume resistivity within the range of about 10⁻⁴ to 10 ohm-cm. Such a volume resistivity allows the article to reflect and absorb incident electromagnetic radiation, thereby shielding electronic components or circuits covered by the article from EMI. The article also shields the outside environment from electromagnetic radiation generated within the article. The composition also provides a surface resistivity within the range of 10⁻² to 10 ohm/square. Such a surface resistivity provides sufficient metal additive on the surface of the article, thereby enabling attachment of solder to the article during SMT processing.

The thermoplastic material has a melting point of greater than about 230°C to allow the thermoplastic material to be used in surface mount technology (SMT) processing. The article and electronic components or circuits covered by the article are affixed to a printed wiring board with SMT processing. Accordingly, SMT processing forms an electrical and mechanical connection of the article to the printed wiring board.

Additives which function as an EMI shield include solderable conductive particles, fibers and flakes. The concentration of the additive suspended in the polymeric material is selected to provide a volume resistivity and surface resistivity within the prescribed ranges.

Other objects and features of the present invention will become apparent from the following detailed description considered in conjunction with the accompanying drawings. It is to be understood, however, that the drawings are designed solely for purposes of illustration and do not serve to limit the invention, for which reference should be made to the appended claims.

### Brief Description of the Drawings

Fig. 1A is a top and side perspective view of an article comprising a surface-mountable EMI shielded plastic cover.
Fig. 1B is a bottom and side perspective view of the cover of Fig. 1A.
Fig. 1C is a top plan view of the cover of Fig. 1A.
Fig. 1D is a side elevational view of the cover of Fig. 1A.
Fig. 1E is a bottom and side perspective view of an alternate embodiment of the cover.
Fig. 2A is a flow diagram of a surface-mount technology (SMT) process useful for attaching the cover to a first side of a printed wiring board (PWB).
Fig. 2B is a flow diagram of a surface-mount technology (SMT) process useful for attaching the cover to a second side of the PWB.
Fig. 3 is a graph of a reflow time-temperature profile used in surface-mount technology (SMT) processing.
Fig. 4A is a perspective view of a PWB after a stenciling step of the SMT process.
Fig. 4B is a perspective view of the PWB after a high speed placement step of the SMT process for placing electronic components in the proximity of the PWB.
Fig. 4C is a perspective view of the PWB after a fine placement step of the SMT process for placing the electronic components on the PWB.
Fig. 4D is a perspective view of a PWB after a high speed placement step of the SMT process for placing covers in the proximity of the PWB.
Fig. 4E is a perspective view of a PWB after a fine placement step of the SMT process for placing the covers on the PWB.

### Detailed Description

Reference will now be made in greater detail to a preferred embodiment of the invention, an example of which is illustrated in the accompanying drawings. Wherever possible, the same reference numerals will be used throughout the drawings and the description to refer to the same or like parts.

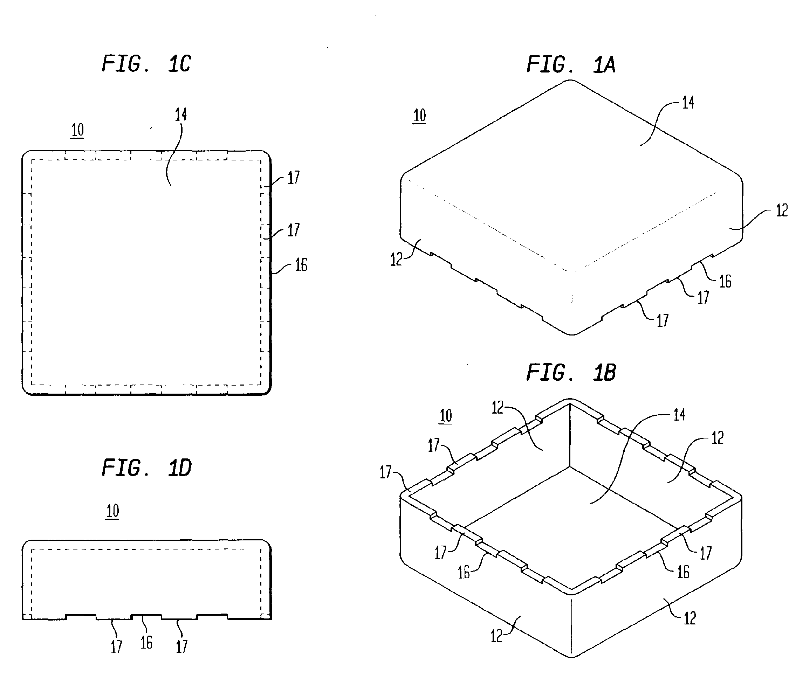

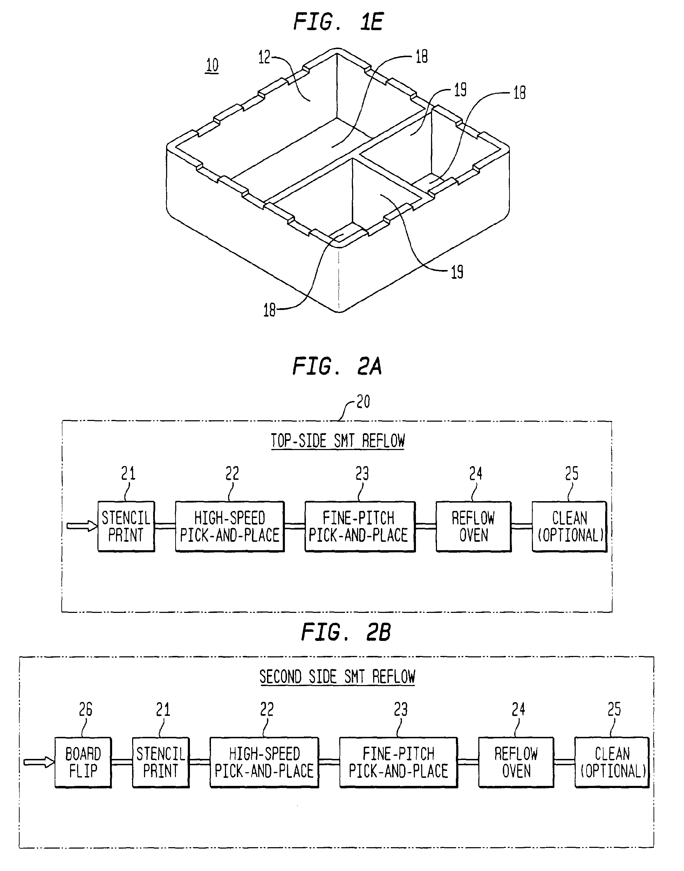

FIGS. 1A-1D illustrate views of article 10 in accordance with the teachings of the present invention. Article 10 is formed of electrically conductive thermoplastic material for providing electromagnetic interference (EMI) shielding and providing a solderable surface. Article 10 is compatible with the surface-mount technology (SMT) process.

Article 10 is formed into a shape having dimensions to cover individual components, for example an IC chip, on a PWB, as described below. Article 10 includes sides 12 formed integrally with top 14. Bottom edges 16 of sides 12 include a plurality of protrusions 17 for providing increased surface area with solder applied to attach article 10 to a PWB (not shown), thereby providing high bond strength of article 10 with the PWB. In the alternative bottom edge 16 can be a substantially straight edge. Article 10 can be an EMI shielded plastic cover having corresponding dimensions to cover an entire PWB or a portion thereof. Article 10 can also have a plurality of subcompartments 18 formed by wall members 19 for EMI shielding of multiple components on a PWB, as shown in Fig. 1E. For example, article 10 can be formed by conventional injection molding processes.

Examples of thermoplastic materials suitable for use in forming article 10 include thermoplastic resins having a melting point of greater than about 230° C. Suitable thermoplastic materials include: aromatic polyamides, such as high temperature nylons (HTNs) having a melting point of about 300°C; aromatic polyesters, such as liquid crystal polymers (LCPs) having a melting point of about 335°C; ketone resins, such as polyaryletherketones (PAEKs) and polyetheretherketones (PEEKs) having a melting point in the range of about 310°C to about 345°C; and polyphenylene sulfides (PPSs) having a melting point in the range of about 275°C to about 290°C. Thermoplastic resins useful for the present invention are available commercially from the following: DuPont Engineering Polymers, Wilmington, DE under trade names of Zenite LCP and Zytel HTN; BASF Corporation, Mount Olive, NJ under the trade name Ultrapek PAEK; Victrex USA, West Chester, PA under the trade name of Victrex PEEK; Amoco Polymers, Alpharetta, GA under the trade name Kadel PAEK; and Phillips Chemical Co., Plastic Division, Houston, TX under the trade name Ryton PPS. It will be appreciated that other thermoplastic polymeric materials suitable for SMT processing known in the art could be used with the teachings of the present invention.

Article 10 has a composition in which a conductive additive is suspended within the thermoplastic material in an amount sufficient to provide a volume resistivity within the range of about 10⁻⁴ to about 10 ohm-cm. Such a volume resistivity allows article 10 to absorb and/or reflect electromagnetic radiation, thereby shielding electronic components covered by article 10 from EMI. Article 10 has a surface resistivity in the range of about 10⁻² to about 10 ohm/square to provide sufficient conductive additive on the outer surface 19 of article 10 for enabling outer surface 19 to be wet by applied solder and to be bonded to the solder after cooling. Processes for molding a composition for enabling a sufficient amount of an additive to be present at the surface of the article to provide the desired range of surface resistivity are known to those skilled in the art.

Suitable electrically conductive additives include metal coated graphite fibers such as, nickel-coated graphite (NiCG) fibers, nickel copper-coated graphite (NiCuCG) fibers, and nickel copper nickel-coated graphite (NiCuNiCG) fibers and metal fibers, such as nickel-coated copper (NiCCu) fibers and stainless steel (SS) fibers. Additives can be in the form of particles, flakes or fibers. The concentration of the additive suspended in the thermoplastic material is selected to provide a volume resistivity and surface resistivity within the prescribed range. Suitable thermoplastic resins with dryblended or compound conductive additives in the appropriate amount are available commercially from RTP Company, Winona, Minnesota.

Conductive fibers typically have a graphite core with a diameter in the range of about 5 microns to about 10 microns and are coated with about 0.5 microns to about 3 microns thick layer of metal. Conductive fibers are generally bundled into about 3,000 to about 12,000 fiber rovings which are impregnated with a resin binder to hold the fibers together. The rovings are chopped into pellets having a length in the range of from about 0.0625 inch to about 0.5 inch to be useful for dry-blending with thermoplastic materials. Suitable conductive additives include metal coated graphite fibers available commercially from Composite Materials, LLC, Mamoroneck, NY, nickel-coated graphite fibers available commercially from INCO Specialty Powder Products, Wyckoff, NJ and stainless steel fibers available commercially from Bekaert Fibre Technologies, Marietta, GA.

The volume resistivity and surface resistivity of article 10 is dependent on the composition and amount of additive that is suspended within the thermoplastic material. It has been found that conductive fibers having an aspect ratio of the length to diameter in the range of about 100:1 to about 2000:1 in an amount of at least about 5% by weight and no greater than about 25% by weight suspended in the thermoplastic material are sufficient to provide a volume resistivity and surface resistivity of article 10 within the prescribed range for EMI shielding.

The thickness of article 10 which provides EMI shielding is dependent on the desired EMI shielding effectiveness based on the concentration of a specific additive suspended in the thermoplastic material which imparts EMI shielding. A suitable thickness of each of article 10 is in the range of about 0.025 inch to about 0.15 inch.

Fig. 2A illustrates a flow diagram of a surface-mount technology (SMT) process 20 for mounting the article and electronic components or circuits to a first side of a PWB. In block 21, solder paste is applied to the PWB with a stencil printing process in which a rubber squeegee pushes a bead of solder paste across the top of a stencil for forcing the solder paste into apertures in the stencil and onto the surface pads of the PWB. Thereafter, the stencil is lifted from the PWB and solder bricks are formed on the surface pads defining positions for placement of the article and electronic components or circuits on the PWB. Conventional solder paste can be a mixture of small spheres of solder metal and solder flux.

In block 22, high-speed-pick-and-place is used to pick up the article, electronic component or circuit, and place it within the proximity of the position indicated by the stencil. In block 23, fine-pitch-pick-and-place is used to place the article, electronic component or circuit on the PWB. Conventional high speed and high accuracy placement equipment such as the GSM platform manufactured by Universal Instrument Corporation in Binghamton, NY, can be used in SMT 20 process. Thereafter, the PWB is subjected to a SMT time-temperature profile for melting the solder paste to attach the placed articles to the PWB and form electrical connections between electrical components or circuits, in block 24.

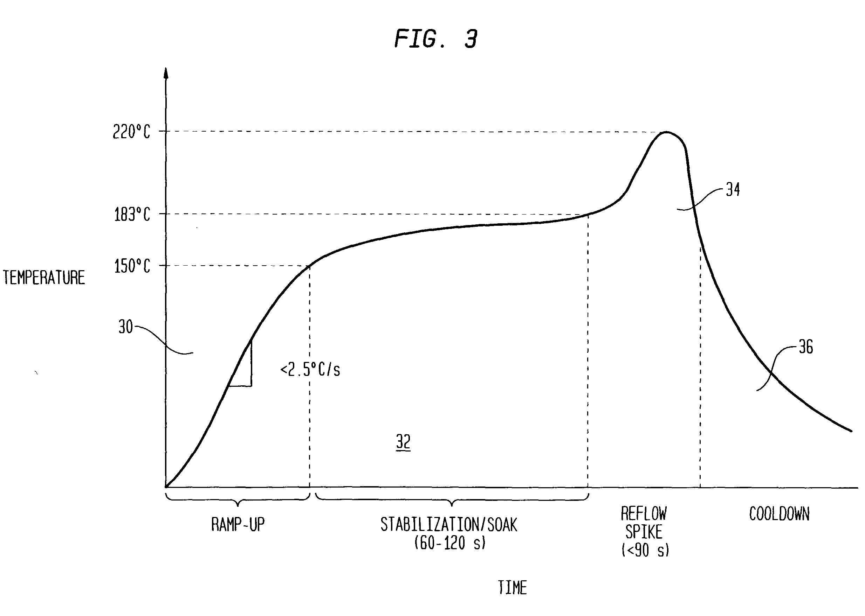

Conventional solder reflow having a maximum temperature in the range of about 200°C to about 235°C can be used in the SMT process. A suitable SMT time-temperature profile is shown in Fig. 3. The maximum reflow temperature is reached over a period of time with a total reflow time-temperature profile consisting of four regions. First region 30 is a preheat temperature region in which heating occurs at no more than about 3°C/sec and typically of about 2 to 2.5°C/sec. First region 30 brings the PWB assembly up to a flux activation temperature of about 130°C to about 150°C. Second region 32 is a temperature stabilization region for eliminating temperature variations, providing time for the activated flux to clean the component leads, PWB pads and solder, and then evaporate. Second region 32 is performed for about 45 to 90 seconds at a temperature of about 140°C to 160°C. Third region 34 is a reflow profile region to allow all solder to reflow smoothly and uniformly. Third region 34 is performed for about 40 sec at a temperature above the solder melting point, typically in the range of about 200°C to about 235°C. Fourth region 36 is a cooldown region for solidifying the solder. In block 25 of Fig. 2A, the PWB is optionally cleaned.

Fig. 2B illustrates a flow diagram of a SMT process for mounting the articles, electronic components or circuits to a second side of the PWB after processing of the first side in Fig. 2A. In block 26, the PWB is flipped for enabling SMT processing on the second side of the PWB. Blocks 21-25 are repeated for SMT processing of the second side of the PWB.

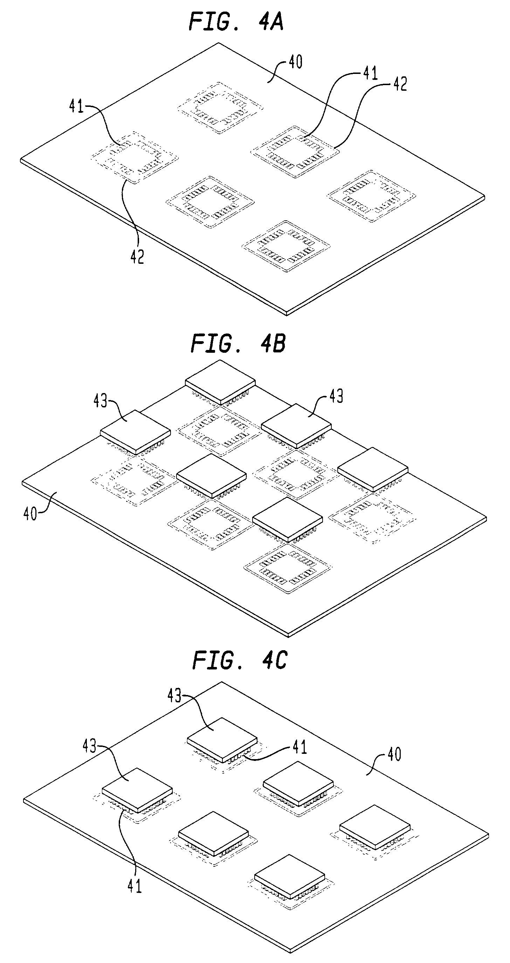

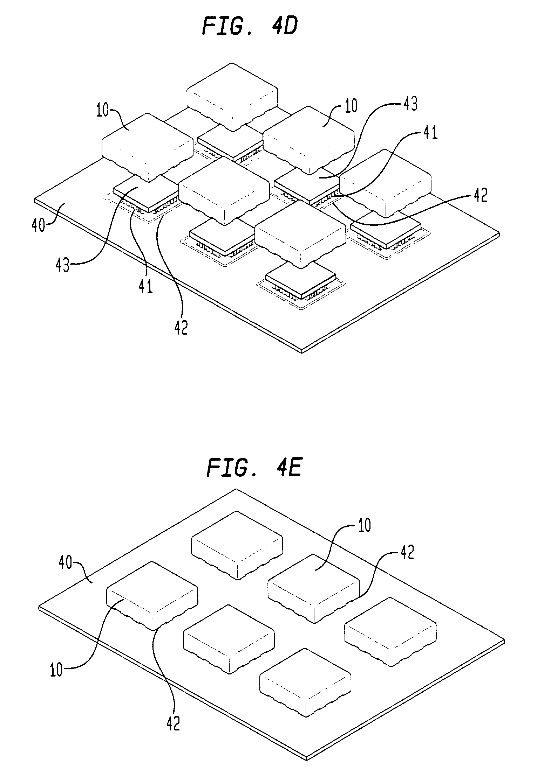

Figs. 4A-4E illustrate attachment of article 10 and electronic components to PWB 40 using SMT process 20. Fig. 4A shows PWB 40 after block 21 of SMT process 20 is performed to apply stencil solder 41 for attachment of electronic components or circuits and solder 42 for attachment of article 10. Fig. 4B illustrates PWB 40 after block 22 of SMT process 20 is performed for high speed placement of electronic components 43 in the proximity of PWB 40. Fig. 4C illustrates PWB 40 after block 23 of SMT process 20 is performed to place electronic components 43 on solder 41 of PWB 40. Fig. 4D illustrates PWB 40 after block 22 of SMT process 20 is performed for providing high speed placement of article 10 in proximity to PWB 40 for covering electronic components 43. Fig. 4E illustrates PWB 40 after block 24 of SMT process 20 is performed to place article 10 on solder 43 of PWB 40 to cover electronic components 43. Thereafter, PWB 40 is sent through a reflow oven and the SMT temperature profile is applied to melt solder 41 and solder 42 for simultaneous mechanical and electrical attachment of electronic components 43 and article 10 to PWB 40.

Article 10 conducts electricity therethrough to provide a path for the electromagnetic wave to solder 43 for grounding article 10 to PWB 40 and providing EMI protection. Article 10 is optionally connected to ground by interconnection to the ground connection of PWB 40 using metal clips, screws, fasteners or a similar conductive device.

It is to be understood that the above-described embodiments are illustrative of only a few of the many possible specific embodiments which can represent applications of the principles of the invention. Numerous and varied other arrangements can be readily devised in accordance with these principles by those skilled in the art without departing from the spirit and scope of the invention.

## Claims

1. A surface-mountable article comprising:
a shielding layer formed of a thermoplastic polymeric material, said thermoplastic material has a melting point of greater than about 230°C, said thermoplastic material is an electromagnetic shielding material having a volume resistivity within the range of about 10⁻⁴ to 10 ohm-cm and is a solderable material having a surface resistivity in the range of about 10⁻² to about 10 ohm/square.

2. The article of claim 1 wherein said thermoplastic polymeric material has a composition in which an additive is suspended within a polymeric material.

3. The article of claim 2 wherein said polymeric material is selected from the group consisting of aromatic polyamides, aromatic polyester, polyacylether ketone, polyether ether ketone and polyphenylene sulfide.

4. The article of claim 3 wherein said additive is present in an amount of at least about 5% by weight of said thermoplastic polymeric material and no greater than about 25% by weight.

5. The article of claim 4 wherein said additive is selected from the group consisting of:
conductive particles, conductive flakes, conductive fibers and conductive powders.

6. The article of claim 5 wherein said conductive fibers have an aspect ratio in the range of about 100:1 to about 2000:1.

7. The article of claim 6 wherein said additive is selected from the group consisting of nickel-coated graphite (NiCG), nickel copper-coated graphite (NiCuCG) fibers, nickel copper nickel-coated graphite (NiCuNiCG) fibers, nickel-coated copper (NiCCu) fibers and stainless steel (SS) fibers.

8. The article of claim 1 wherein said article is a cover having a top portion integrally formed with side portions and being adapted to cover a circuit or electronic component on a printed wiring board.

9. The article of claim 8 further comprising protrusions formed on bottom edges of said side portions.

10. The article of claim 8 wherein said cover and said circuit or electronic component are attached simultaneously to said printed wiring board with surface mount technology processing.

11. The article of claim 10 wherein said article is to be grounded to said printed wiring board after said surface mount technology processing.

12. The article of claim 8 wherein said article further comprises:
at least one wall member extending from said top portion of said cover for forming at least one sub-compartment.

13. The article of claim 1 wherein-said article is formed using injection molding.

14. A method for providing electromagnetic shielding of an electronic component or circuit comprising the steps of
applying a stencil of solder of an electronic component or circuit and a stencil of an article to a printed wiring board;
placing an electronic component or circuit on said stencil of said solder of said electronic component or circuit;
placing an article on said stencil of said article, said article comprising a shielding layer formed of a thermoplastic polymeric material, said thermoplastic material has a melting point of greater than about 230°C and is an electromagnetic shielding material having a volume resistivity within the range of about 10⁻⁴ to 10 ohm-cm and a solderable material having a surface resistivity in the range of about 10⁻² to about 10 ohm/square;
heating said printed wiring board to a reflow temperature of surface mount technology processing for melting said stencil of solder of said electronic component or circuit and said stencil of solder of said article; and
cooling said printed wiring board, wherein said electronic component or circuit and said article are attached to said printed wiring board.

15. The method of claim 14 wherein said thermoplastic polymeric material has a composition in which an additive is suspended within a polymeric material.

16. The method of claim 15 wherein said polymeric material is selected from the group consisting of aromatic polyamides, aromatic polyester, polyacylether ketone, polyether ether ketone and polyphenylene sulfide.

17. The method of claim 14 wherein said additive is selected from the group consisting of conductive particles, conductive flakes, conductive fibers and conductive powders.

18. The method of claim 14 wherein said additive is selected from the group consisting of nickel-coated graphite (NiCG), nickel copper-coated graphite (NiCuCG) fibers, nickel copper nickel-coated graphite (NiCuNiCG) fibers, nickel-coated copper (NiCCu) fibers and stainless steel (SS) fibers.

19. The method of claim 14 wherein said article is a cover having a top portion integrally formed with side portions and being adapted to cover a circuit or electronic component on a printed wiring board.
